(19) Europäisches Patentamt
European Patent Office
Office européen des brevets

(11) **EP 2 629 550 B1**

(12) **EUROPÄISCHE PATENTSCHRIFT**

(45) Veröffentlichungstag und Bekanntmachung des Hinweises auf die Patenterteilung:
**14.10.2015 Patentblatt 2015/42**

(51) Int Cl.:
*H04R 25/00* *(2006.01)*    *H03H 21/00* *(2006.01)*
*H04R 3/00* *(2006.01)*

(21) Anmeldenummer: **13152490.2**

(22) Anmeldetag: **24.01.2013**

(54) **Hörvorrichtung mit einem adaptiven Filter und Verfahren zum Filtern eines Audiosignals**

Hearing device with adaptive filter and method of filtering an audio signal

Prothèse auditive avec un filtre adaptatif et procédé pour le filtrage d'un signal audio

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.02.2012 DE 102012202469**

(43) Veröffentlichungstag der Anmeldung:
**21.08.2013 Patentblatt 2013/34**

(73) Patentinhaber: **Siemens Medical Instruments Pte. Ltd.**
**Singapore 139959 (SG)**

(72) Erfinder:
• **Martin, Rainer, Prof.**
**44803 Bochum (DE)**
• **Pilgrim, Thomas**
**91052 Erlangen (DE)**
• **Puder, Henning, Dr.**
**91052 Erlangen (DE)**
• **Schasse, Alexander**
**44892 Bochum (DE)**
• **Sörgel, Wolfgang**
**91052 Erlangen (DE)**

(74) Vertreter: **FDST Patentanwälte**
**Nordostpark 16**
**90411 Nürnberg (DE)**

(56) Entgegenhaltungen:
**EP-A2- 1 251 715    DE-A1-102010 026 884**

**Beschreibung**

Die Erfindung betrifft eine Hörvorrichtung und ein Verfahren, durch welche ein Audiosignal mittels einer Transformationseinrichtung erster Stufe in mehrere Teilbandsignale transformiert wird und zumindest einige dieser Teilbandsignale mittels einer Transformationseinrichtung zweiter Stufe in Subteilbandsignale transformiert werden. Eine Hörvorrichtung und ein Verfahren dieser Art sind aus der deutschen Patentanmeldung mit dem Aktenzeichen 10 2010 026 884 bekannt. Unter einer Hörvorrichtung wird hier jedes in oder am Ohr tragbare, schallausgebende Gerät verstanden, insbesondere ein Hörgerät, ein Hörset und ein Kopfhörer. Darüber hinaus kann es sich bei der erfindungsgemäßen Hörvorrichtung insbesondere auch um ein Mobiltelefon handeln.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

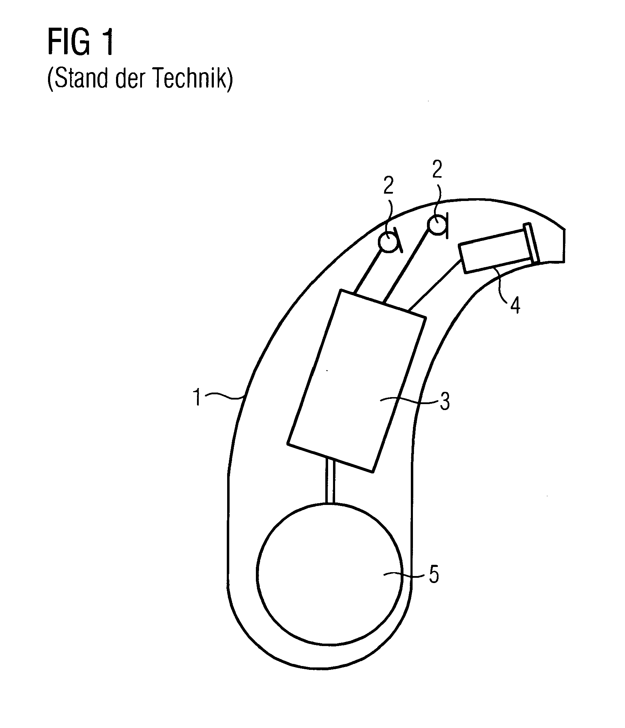

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Energieversorgung des Hörgeräts und insbesondere die der Signalverarbeitungseinheit 3 erfolgt durch eine ebenfalls ins Hörgerätegehäuse 1 integrierte Batterie 5.

Bei der Signalverarbeitungseinrichtung 3 ist deren Bedarf an elektrischer Leistung davon abhängig, wie viele Rechenoperationen sie innerhalb einer bestimmten Zeit durchführen muss. Um die Lebensdauer der Batterie 5 nicht unnötig zu verkürzen, ist man daher bestrebt, die Verarbeitung eines Audiosignals, also eines Signals des Eingangswandlers oder eines Telekommunikationssignals, möglichst effizient zu gestalten, um unnötige Rechenoperationen zu vermeiden.

In der oben genannten Patentanmeldung ist ein Verfahren beschrieben, mittels welchem auf der Grundlage einer zweistufigen spektralen Transformation das Audiosignal zunächst in Teilbandsignale zerlegt wird und anschließend in der zweiten Stufe bedarfsweise einige der Teilbandsignale wiederum in Subteilbandsignale transformiert werden. Die Teilbandsignale können dabei in der für Hörgeräte bekannten Weise verarbeitet werden, um hierdurch z.B. die Pegel der einzelnen Teilbandsignale entsprechend einem Hörvermögen des Benutzers der Hörvorrichtung zu verstärken. Durch Aufteilen eines Teilbandsignals in die Subteilbandsignale wird dieser typische Aufbau einer Hörvorrichtung dahingehend erweitert, dass die Subteilbandsignale schmalbandig genug sind, um z.B. in einem Sprachsignal gezielt ein Störgeräusch in einigen der Subteilbandsignale unterdrücken zu können, ohne ein zugleich in den übrigen Subteilbandsignalen enthaltenes Sprachsignal signifikant in Mitleidenschaft zu ziehen. Diese Störgeräuschproduktion basiert dabei auf dem Prinzip, für jede der Subteilbandsignale, also der Signale der zweiten Transformationsstufe, einen Dämpfungsfaktor zu berechnen, dessen Wert davon abhängt, ob in dem Subteilbandsignal überwiegend ein unerwünschtes Rauschen oder ein Nutzsignal, wie etwa Sprache, enthalten ist. Die Berechnung des Gewichtungsfaktors wird dabei in Abhängigkeit von dem Verlauf des Subteilbandsignals durchgeführt, d. h. die einzelnen Dämpfungsfaktoren sind adaptiv.

Werden nun sehr viele der Teilbandsignale mittels der zweiten Transformationsstufe in Subteilbandsignale aufgeteilt und wird zu jedem dieser Subteilbandsignale ein Dämpfungsfaktor berechnet, so kann dies dazu führen, dass die Verarbeitung eines Audiosignals sehr viele Rechenschritte pro gegebener Zeiteinheit erfordert. In Abhängigkeit von der verwendeten Signalverarbeitungseinrichtung und der Kapazität der verwendeten Batterie kann es daher in einigen Fällen dazu kommen, dass die Signalverarbeitung entweder überfordert ist oder die Batterie sehr häufig gewechselt werden muss.

Eine Aufgabe der vorliegenden Erfindung besteht darin, bei einer Hörvorrichtung, die ein Audiosignal mittels eines adaptiven Filters verarbeitet, einen effizienten Betrieb zu ermöglichen.

Die Aufgabe wird durch ein Verfahren gemäß Patentanspruch 1 sowie eine Hörvorrichtung gemäß Patentanspruch 12 gelöst. Vorteilhafte Weiterbildungen der Erfindung sind durch die Unteransprüche gegeben.

Das erfindungsgemäße Verfahren dient zum adaptiven Filtern eines Audiosignals, d. h. zum Filtern in Abhängigkeit von dem Verlauf des Audiosignals selbst. Hierdurch kann beispielsweise in dem Audiosignal ein Rauschanteil unterdrückt werden, während zugleich ein Nutzsignalanteil erhalten bleibt. Genauso kann durch eine adaptive Filterung eine Betonung einzelner Signalanteile, beispielsweise von Konsonanten in einem Sprachsignal, erreicht werden. Das Verfahren baut hierbei auf einer mehrstufigen Filterbankanordnung auf, d. h. das Audiosignal wird durch eine erste Transformationsstufe transformiert, wodurch in mehreren Kanälen jeweils ein Teilbandsignal erzeugt wird. Unter einem Teilbandsignal ist hierbei ein Signal des Kanals zu verstehen, welches die in einem vorbestimmten spektralen Band (Kanal) des Audiosignals enthaltenen Informationen repräsentiert. Bei der ersten Transformationsstufe kann es sich beispielsweise um eine Filterbank handeln, wie sie typischerweise in einem Hörgerät dazu verwendet wird, ein Audiosignal beispielsweise in zweiunddreißig oder mehr Teilbandsignale zu zerlegen, um dann einzelne Teilbandsignale gemäß einem Hörvermögen eines Benutzers des Hörgeräts im Pegel anzuheben.

In zumindest einigen dieser Kanäle wird das jeweilige Teilbandsignal von einer Filtereinrichtung des Kanals adaptiv gefiltert. Es müssen nicht alle Kanäle betroffen sein. Für die adaptive Filterung ist zum Unterscheiden zwischen Nutzsignal und Störsignal eine Frequenzauflösung nötig, die größer ist als die durch die erste Transformationsstufe erreichte. Hierzu wird in jedem der Kanäle, in denen das Teilbandsignal von einer Filtereinrichtung gefiltert wird, deren Teilbandsignal zunächst von einer zweiten Transformationsstufe transformiert und auf mehrere Subkanäle des jeweiligen Kanals aufgeteilt. In jedem Subkanal wird dann von der Filtereinrichtung des Kanals ein Gewichtungsfaktor für das Signal dieses Subkanals festgelegt. Durch diesen Gewichtungsfaktor wird jeweils festgelegt, ob das Signal dieses Subkanals einerseits verstärkt oder sein Pegel zumindest beibehalten werden soll oder ob das Signal stattdessen gedämpft werden soll, weil es beispielsweise hauptsächlich ein Störsignal, also etwa ein Rauschen, darstellt. Teilt man nun ein Audiosignal zunächst in Kanäle auf und dann mehrere dieser Kanäle wieder in Subkanäle, so bedeutet dies, das zum adaptiven Filtern des Audiosignals eine entsprechend große Anzahl von Gewichtungsfaktoren festzulegen ist, nämlich einer pro Subkanal. Bei der oben beschriebenen Filterbank mit zweiunddreißig Kanälen und einer anschließenden Aufteilung dieser Kanäle in jeweils beispielsweise sechzehn Subkanäle kann dies bedeuten, dass fünfhundertzwölf Gewichtungsfaktoren ermittelt werden müssen. Eine Signalverarbeitungseinrichtung, wie sie typischerweise in einem Hörgerät oder einem Mobiltelefon bereitgestellt ist, kann je nach hierbei verwendetem Filteralgorithmus durchaus an die Grenze ihrer Rechenleistung gelangen. Das erfindungsgemäße Verfahren ermöglicht es aber nun, die adaptive Filterung besonders effizient durchzuführen, sodass sich die Anzahl der benötigten Rechenschritte zum Ermitteln der Gewichtungsfaktoren um fünfzig Prozent und mehr reduzieren lässt. Hierzu wird bei zumindest einer der Filtereinrichtungen (d.h. also in zumindest einem Kanal), der Gewichtungsfaktor zumindest eines Subkanals zwar in Abhängigkeit von dem Signal des Subkanals selbst durch Berechnen festgelegt, wie es zum Ermitteln eines adaptiven Gewichtungsfaktors eben nötig ist. Dieser berechnete Gewichtungsfaktor wird dann aber von dieser Filtereinrichtung nicht nur zum Filtern des Subkanals selbst verwendet, sondern zusätzlich auch an zumindest eine andere Filtereinrichtung übertragen. Bei der zumindest einen anderen Filtereinrichtung wird dann in zumindest einem von deren Subkanälen der Gewichtungsfaktor nicht durch Berechnung eines eigenen Gewichtungsfaktors auf der Grundlage des Signals des eigenen Subkanals, sondern auf der Grundlage des empfangenen, von der anderen Filtereinrichtung bereits berechneten Gewichtungsfaktors festgelegt. Ein und derselbe von der ersten Filtereinrichtung berechnete Gewichtungsfaktor wird also in mehreren Subkanälen verwendet. Im Folgenden werden im Zusammenhang mit dem Übertragen eines berechneten Gewichtungsfaktors die Formulierungen "zu einer Filtereinrichtung eines anderen Kanals" und "zu einem anderen Kanal" und "zu einem Subkanal eines anderen Kanals" synonym verwendet. Sie beschreiben im Endeffekt denselben Vorgang.

Durch das erfindungsgemäße Verfahren lässt sich eine adaptive Filterung mit einer auditiven Qualität erreichen, die in Hörtests genauso gut abschneidet wie eine adaptive Filterung, bei der zu jedem Subkanal der Gewichtungsfaktor einzeln und in Abhängigkeit von dem jeweiligen Signal des Subkanals selbst berechnet wird. Die Erfindung macht sich hierbei die Erkenntnis zunutze, dass bei einer mehrstufigen Filterbank das ursprüngliche Audiosignal durch die Signale der Subkanäle in redundanter Weise repräsentiert ist. Mit anderen Worten lässt sich zu einem bestimmten Subkanal, für welchen ein Gewichtungsfaktor in Abhängigkeit von dem Signal des Subkanals selbst berechnet wird, zumindest ein anderer Subkanal finden, dessen Signal sich sehr ähnlich verhält. Ergibt also die Berechnung des Gewichtungsfaktors einen sehr kleinen Wert, weil etwa durch die entsprechende Filtereinrichtung erkannt wird, dass es sich bei dem Signal in dem Subkanal hauptsächlich um ein unerwünschtes Rauschen handelt, so lässt sich aufgrund der Erkenntnis, dass das Audiosignal redundant repräsentiert ist, auch ein weiterer Subkanal finden, bei dem ebenfalls davon ausgegangen werden kann, dass er hauptsächlich ein Rauschen enthält. Entsprechend muss für diesen weiteren Subkanal der Gewichtungsfaktor nicht neu berechnet werden, sondern es kann der bereits berechnete Gewichtungsfaktor übernommen werden. So kann es beispielsweise bei einer mehrstufigen Filterbank vorkommen, dass sich zwei Subkanäle spektral überschneiden. Mit anderen Worten repräsentieren die beiden Subkanäle zumindest teilweise denselben spektralen Anteil des Audiosignals. In einem solchen Fall kann der Gewichtungsfaktor, der zu einem der Subkanäle berechnet wurde, ohne signifikante Einbuße der Audioqualität auch für den anderen Subkanal verwendet werden. Ganz besonders günstig für die Audioqualität ist es hierbei, wenn die beiden Subkanäle gleiche Mittenfrequenzen aufweisen.

Um herauszufinden, zu welchen Subkanälen ein berechneter Gewichtungsfaktor zweckmäßigerweise übertragen werden kann, werden gemäß einer Ausführungsform des erfindungsgemäßen Verfahrens jeweils die Kreuzkorrelationen zwischen einem Signal eines Subkanals eines ersten Kanals einerseits und den Signalen der Subkanäle eines anderen Kanals andererseits berechnet. Der zu dem ersten Subkanal berechnete Gewichtungsfaktor wird dann zweckmäßigerweise zu denjenigen der Subkanäle des anderen Kanals hin übertragen, bei welchen ein Wert für die Kreuzkorrelation größer als ein vorbestimmter Schwellenwert ist. Die Kreuzkorrelation wird dabei zweckmäßigerweise auf der Grundlage von Testsignalen oder aufgrund einer mathematischen Analyse bereits bei der Entwicklung der Hörvorrichtung berechnet.

In einem Subkanal, in welchem der Gewichtungsfaktor nicht berechnet, sondern von einem anderen Subkanal übernommen werden soll, kann der Gewichtungsfaktor aus einem oder aber auch aus mehreren empfangenen, bereits berechneten Gewichtungsfaktoren gebildet werden. Beispielsweise ist denkbar, die empfangenen Gewichtungsfaktoren in demjenigen Ausmaß zu skalieren (als mit einem Wert von Null bis Eins zu multiplizieren), in welchem der Subkanal mit den entsprechenden Subkanälen korreliert ist. Die skalierten Gewichtungsfaktoren können dann zu dem gesuchten Gewichtungsfaktor kombiniert werden. Als besonders effizient hat sich allerdings herausgestellt, lediglich einen einzigen empfangenen Gewichtungsfaktor herzunehmen und diesen auch als Gewichtungsfaktor für den aktuellen Subkanal unverändert zu übernehmen.

Eine weitere, besonders effiziente Implementierung des erfindungsgemäßen Verfahrens ergibt sich, wenn berechnete Gewichtungsfaktoren von mehreren benachbarten Subkanälen eines ersten Kanals gruppenweise zu einer anderen Filtereinrichtung übertragen werden. Dies geschieht bevorzugt gemäß einem vorbestimmten Kopiermuster, nach welchem die berechneten Gewichtungsfaktoren in einem Speicher der zweiten Filtereinrichtung übertragen werden, wo sie dann Gewichtungsfaktoren entsprechender benachbarter Subkanäle des zweiten Kanals bilden.

Besonders drastisch lässt sich der Berechnungsaufwand für die adaptive Filterung reduzieren, wenn zumindest einer der berechneten Gewichtungsfaktoren an mehrere andere Filtereinrichtungen übertragen wird. In der gleichen Weise hat es sich als zweckmäßig erwiesen, wenn auch innerhalb zumindest einer der Filtereinrichtungen ein Gewichtungsfaktor zu einem anderen Subkanal derselben Filtereinrichtung übertragen wird. Auch innerhalb eines Kanals kann nämlich ein bereits berechneter Gewichtungsfaktor mehrfach genutzt werden. Welche Subkanäle sich hier eignen, kann beispielsweise durch Berechnen der Kreuzkorrelationen zwischen den Subkanälen des Kanals erkannt werden.

Für die auditive Qualität des gefilterten Audiosignals hat es sich auch als besonders günstig erwiesen, Gewichtungsfaktoren stets alle in der Frequenz entweder nur aufwärts oder nur abwärts zu übertragen, also hin zu Filtereinrichtungen solcher Kanäle, die eine höhere (frequenzaufwärts) bzw. eine niedrigere (frequenzabwärts) Mittenfrequenz aufweisen als derjenige Kanal, in welchem der Gewichtungsfaktor des Subkanals berechnet wurde.

In welchen der Subkanäle die Gewichtsfaktoren in Abhängigkeit von den jeweiligen Signalen der Subkanäle selbst berechnet werden und in welchen Subkanälen dagegen bereits berechnete Gewichtungsfaktoren empfangen und für die Filterung übernommen werden, kann auf der Grundlage der beschriebenen Kriterien frei festgelegt werden. Es ist also möglich, dass in einer bestimmten Filtereinrichtung die Gewichtungsfaktoren in einigen der Subkanäle durch Berechnen festgelegt werden und die Gewichtungsfaktoren anderer Subkanäle von wenigstens einer anderen Filtereinrichtung empfangen werden. Als weitere Möglichkeit kann auch vorgesehen werden, dass ein Subkanal mit einem vorbestimmten konstanten Wert gewichtet wird, wenn der Anteil des Signals dieses Subkanals am gesamten Audiosignal beispielsweise unbedeutend ist. Wie bereits erwähnt, kann auch ein Gewichtungsfaktor innerhalb ein und derselben Filtereinrichtung zwischen Subkanälen übertragen werden.

Das eigentliche Filtern des Teilbandsignals eines Kanals mittels der einzelnen Gewichtungsfaktoren für die Subkanäle kann auf zwei unterschiedliche Weisen geschehen. Gemäß einer Ausführungsform des erfindungsgemäßen Verfahrens wird das Signal jedes Subkanals mit dem für diesen Subkanal festgelegten Gewichtungsfaktor gewichtet, also entweder unmittelbar multipliziert oder in einer vergleichbaren Weise skaliert. Anschließend werden dann die gewichteten Signale aller Subkanäle des Kanals zusammen durch eine Rücktransformationsstufe zurück transformiert und zu einem gefilterten Teilbandsignal (erster Stufe) kombiniert. Bei der Rücktransformation handelt es sich dabei um einen Vorgang, der invers zu dem Transformationsvorgang der zweiten Transformationsstufe ist, mittels welcher das Teilbandsignal auf die Subkanäle aufgeteilt wurde. Insgesamt ergibt diese Form des adaptiven Filterns den Vorteil, dass jeder Subkanal gezielt durch einen für ihn bestimmten Gewichtungsfaktor beeinflusst werden kann und somit in dem Audiosignal gezielt bestimmte Signalanteile unterdrückt (Rauschsignal) bzw. unverzehrt (Nutzsignal) übertragen werden.

Eine andere Möglichkeit der Filterung auf Grundlage der Gewichtungsfaktoren ergibt sich, wenn nicht die Signale selbst, sondern die Gewichtungsfaktoren aller Subkanäle durch eine Rücktransformationsstufe gemeinsam rücktransformiert werden und zu einer Filterfunktion kombiniert werden. Diese Filterfunktion wird dann dazu genutzt, ein gefiltertes Teilbandsignal durch Filtern des Teilbandsignals mittels der Filterfunktion zu erzeugen. Diese Ausführungsform des erfindungsgemäßen Verfahrens weist den Vorteil auf, dass sich durch entsprechende Fensterung der Filterfunktion zum einen der Aufwand zum Berechnen des gefilterten Teilbandsignals noch einmal signifikant reduzieren lässt und zum anderen auch eine Filterung mit einer sehr kurzen Zeitverzögerung möglich ist. Des Weiteren basiert diese Ausführungsform des Verfahrens auf der Erkenntnis, dass z.B. das Verfahren von Löllmann und Vary ((H. W. Löllmann und P. Vary, "Low delay filter-banks für speech und audio processing", in Eberhard Hänsler und Gerhard Schmidt: Speech and Audio Processing in Adverse Environments, Springer Berlin Heidelberg, 2008) nicht nur für das Zeitsignal verwendet werden kann, wie es Löllmann und Vary vorsehen, sondern auch auf ein spektrales Signal oder Teilbandsignal, wie es in den Kanälen am Ausgang der ersten Transformationsstufe vorliegt. Insbesondere ist hier anzumerken, dass das Verfahren auch auf die in der Regel komplexwertigen Teilbandsignale einer solchen Transformationsstufe anwendbar ist.

Neben dem beschriebenen erfindungsgemäßen Verfahren umfasst die Erfindung auch eine erfindungsgemäße Hörvorrichtung. Bei dieser sind all diejenigen Komponenten bereitgestellt, die zum Umsetzen des erfindungsgemäßen Verfahrens benötigt werden. So ist eine Transformationseinrichtung erster Stufe vorgesehen, die dazu ausgelegt ist, ein Signal durch Transformieren auf mehrere Kanäle aufzuteilen. Für zumindest zwei dieser Kanäle ist jeweils eine Transformationseinrichtung zweiter Stufe vorgesehen, die dazu ausgelegt ist, das Signal des jeweiligen Kanals (oben als Teilbandsignal bezeichnet) durch Transformieren auf Subkanäle des Kanals aufzuteilen. Bei den Transformationseinrichtungen kann es sich jeweils z. B. um eine spektrale Transformation, insbesondere eine diskrete Fourier-Transformation, handeln oder auch um eine Filterbank, wie etwa eine Polyphasenfilterbank. Auch eine Kombination ist verwendbar, etwa in Form einer Filterbank auf Grundlage einer diskreten Fourier-Transformation.

In jedem Kanal, der eine Transformationseinrichtung zweiter Stufe aufweist, ist zudem eine Filtereinrichtung vorgesehen, von denen jede dazu ausgelegt ist, das Signal des Kanals zu filtern. Wie bereits beschrieben, geschieht die Filterung dabei auf der Grundlage von Gewichtungsfaktoren die zu den einzelnen Subkanälen des Kanals ermittelt werden. Um hierbei den Berechnungsaufwand beim adaptiven Filtern gering zu halten, weist die Filtereinrichtung eines Kanals in nur einigen der Subkanäle jeweils eine Berechnungseinrichtung auf, die dazu ausgelegt ist, den Gewichtungsfaktor des Subkanals tatsächlich zu berechnen und zwar dann eben in Abhängigkeit von dem Signal des Subkanals. Eine solche Berechungseinrichtung wird hier als Schätzeinrichtung bezeichnet. In zumindest einigen der anderen Subkanäle weist die Filtereinrichtung keine solche Schätzeinrichtung, sondern nur eine Empfangseinrichtung auf, die dazu ausgelegt ist, einen berechneten Gewichtungsfaktor von einer anderen Filtereinrichtung zu empfangen und als den Gewichtungsfaktor für den eigenen Subkanal festzulegen.

Bei den Schätzeinrichtungen handelt es sich bevorzugt um einen statistischen Schätzer für einen Nutzsignalanteil des Signals des jeweiligen Subkanals, also etwa um ein Wiener-Filter. Die Gewichtungsfaktoren sind dann jeweils sogenannte Filtergains. Statistische Schätzer haben sich als sehr zweckmäßig für das adaptive Filtern von Audiosignalen erwiesen.

Um einen berechneten Gewichtungsfaktor möglichst wirkungsvoll in mehreren Subkanälen nutzen zu können, ist zweckmäßigerweise vorgesehen, dass sich bei der Transformationseinrichtung erster Stufe benachbarte Kanäle spektral überlappen. Im Zusammenhang mit der Erfindung soll dies bedeuten, dass die Übertragungsfunktionen zweier benachbarter Kanäle jeweils einen Durchlassbereich aufweisen und sich diese Durchlassbereiche überschneiden. Als Durchlassbereich ist derjenige Frequenzbereich zu verstehen, dessen Mittenfrequenz durch das Hauptmaximum der Übertragungsfunktion des Kanals festgelegt ist und dessen Bandbreite durch die erste Nullstelle rechts und links des Hauptmaximums begrenzt ist. Als ein Vorteil überlappender Durchlassbereiche ergibt sich, dass die Gesamt-übertragungsfunktion der Transformationseinrichtung erster Stufe einen besonders glatten spektralen Verlauf aufweist und somit das Audiosignal nicht übermäßig durch das Transformieren selbst verzerrt wird. Zugleich ergibt sich als weiterer Vorteil aber auch die redundante Repräsentation, die zum Einsparen von Rechenoperationen in der beschriebenen Weise genutzt werden kann.

Bevorzugt wird die Hörvorrichtung dabei in der Weise ausgestaltet, dass sich ein Subkanal eines ersten Kanals und ein Subkanal eines anderen, zweiten Kanals spektral in der Weise überlappen, dass sie dieselbe Mittenfrequenz aufweisen. Hierdurch ergibt sich der Vorteil, dass die Übertragung des Gewichtungsfaktors des Subkanals des ersten Kanals auf den Subkanal des zweiten Kanals nur eine sehr kleine, in der Regel nicht wahrnehmbare Verzerrung ergibt, wenn man diese Art der Filterung mit der gängigen Filterung vergleicht, bei welcher die Gewichtungsfaktoren in beiden Kanälen explizit berechnet werden.

Je nach Verwendungszweck kann die Hörvorrichtung auch eine Rücktransformationseinrichtung aufweisen, die dazu ausgelegt ist, Ausgangssignale der Filtereinrichtungen zurück zu transformieren und hierdurch ein gefiltertes Audiosignal zu erzeugen, das dann beispielsweise über einen Hörer an ein Ohr des Benutzers der Hörvorrichtung abgestrahlt werden kann. Durch die Rücktransformation ist dabei insbesondere eine Transformation der gefilterten Teilbandsignale realisiert, die invers zu der Transformation der ersten Stufe ist.

Zu der Erfindung gehören noch weitere Ausführungsformen der erfindungsgemäßen Hörvorrichtung. Diese Weiterbildungen weisen Merkmale auf, wie sie bereits im Zusammenhang mit dem erfindungsgemäßen Verfahren beschrieben worden sind. Aus diesem Grund sind diese übrigen Weiterbildungen der erfindungsgemäßen Hörvorrichtung hier nicht noch einmal beschrieben. Genauso gehören zu der Erfindung auch Weiterbildungen des erfindungsgemäßen Verfahrens, die Merkmale aufweisen, wie sie hier im Zusammenhang mit der erfindungsgemäßen Hörvorrichtung beschrieben sind. Auch diese Weiterbildungen des erfindungsgemäßen Verfahrens sind hier deshalb nicht noch einmal erläutert.

Schließlich wird hier noch darauf aufmerksam gemacht, dass die beschriebene Analysefilterbank auch mehr als zwei Transformationsstufen aufweisen kann, wobei dann entsprechend auch das erfindungsgemäße Verfahren nicht zwingend auf der Grundlage von Signalen zweier unmittelbar aufeinander folgender Transformationsstufen durchgeführt werden muss.

Im Folgenden wird die Erfindung noch einmal konkreter anhand von Ausführungsbeispielen näher erläutert. Dazu zeigt:

FIG 1    einen schematischen Aufbau eines Hörgeräts gemäß dem Stand der Technik,

FIG 2    ein schematisiertes Blockdiagramm einer Signalverarbeitungseinrichtung einer Ausführungsform der erfindungsgemäßen Hörvorrichtung,

FIG 3    ein Diagramm mit einem schematisierten Verlauf von Übertragungsfunktionen einer Transformationseinheit erster Stufe der Hörvorrichtung von FIG 2,

FIG 4    ein Diagramm mit einem schematisierten Verlauf einer Übertragungsfunktion einer Transformationseinrichtung zweiter Stufe der Hörvorrichtung von FIG 2,

FIG 5    ein schematisiertes Blockdiagramm zweier Filtereinrichtungen der Hörvorrichtung von FIG 2,

FIG 6    ein Diagramm zu schematisierten Übertragungsfunktionen zweier Subkanäle mit gemeinsamer Mittenfrequenz, wie sie die Hörvorrichtung von FIG 2 aufweisen kann,

FIG 7    ein Diagramm zu Korrelationswerten zwischen Subkanälen der Hörvorrichtung von FIG 2,

FIG 8    ein Diagramm zu einem Kopiermuster für Gewichtungsfaktoren,

FIG 9    ein Diagramm zu einem weiteren Kopiermuster für Gewichtungsfaktoren,

FIG 10   ein Diagramm zu einem dritten Kopiermuster für Gewichtungsfaktoren und

FIG 11   das Ergebnis eines Hörtests.

Die Beispiele stellen bevorzugte Ausführungsformen der Erfindung dar.

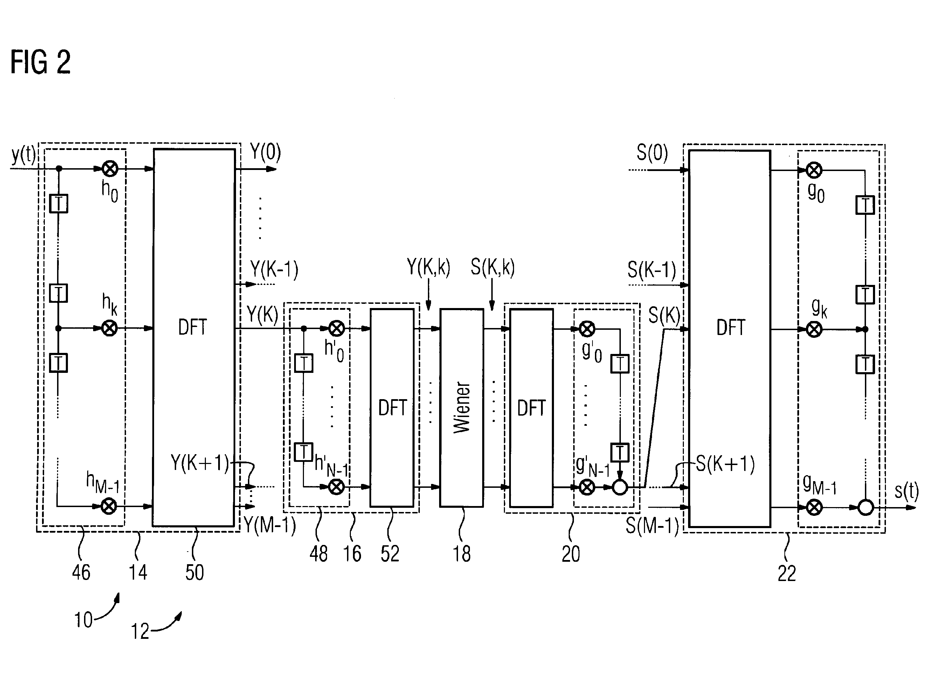

In FIG 2 ist von einer Hörvorrichtung 10 eine Signalverarbeitungseinrichtung 12 gezeigt. Bei der Hörvorrichtung 10 kann es sich um ein Audiogerät wie etwa ein Mobiltelefon oder ein Hörgerät handeln. Generell ist unter einer Hörvorrichtung hier jedes Gerät zu verstehen, in welchem eine zumindest zweistufige Filterbank für eine spektrale Signalanalyse (Analysefilterbank) eingesetzt werden kann. Bei der Signalverarbeitungseinrichtung 12 kann es sich dabei beispielsweise um einen digitalen Signalprozessor (DSP), einen ASIC (application specific integrated circuit), ein FPGA (field programmable gate array) oder eine CPU (general purpose processing unit) dieses Geräts oder aber auch eine Kombination aus einer oder mehrerer von diesen handeln.

In dem Beispiel von FIG 2 wird ein digitalisiertes Eingangssignal y (t) adaptiv gefiltert, und das derart gefilterte Signal als Ausgangssignal s (t) in Form eines Schallsignals an einen Benutzer der Hörvorrichtung 10 ausgegeben. Bei dem Eingangssignal y (t) handelt es sich um ein Audiosignal (d.h. ein Signal im Bereich zwischen 0 Hz und 20 kHz), das von der Signalverarbeitungseinrichtung 12 adaptiv gefiltert wird. Bei dem Ausgangssignal s (t) ist im Vergleich zum Eingangssignal y (t) ein Rauschanteil vermindert, während zugleich ein Nutzsignalanteil, etwa ein Sprachsignalanteil oder ein Musiksignal, nur unwesentlich verzerrt ist. Das Eingangssignal y (t) wird dazu von einer Transformationseinrichtung 14 auf insgesamt N Kanäle aufgeteilt, in denen das Audiosignal durch (komplexwertige) Teilbandsignale Y (0), ..., Y (K-1), Y (K), Y (K+1), ... Y (M-1) repräsentiert ist. Der Übersichtlichkeit halber sind in FIG 2 nur einige der Kanäle und die zugehörigen Teilbandsignale dargestellt. Die übrigen Kanäle sind durch Auslassungszeichen (...) angedeutet. Im Folgenden wird auf die einzelnen Kanäle mittels ihres Index Bezug genommen, d. h. die Transformationseinrichtung 14 weist ausgangsseitig die Kanäle 0 bis (M-1) auf.

Die Signalverarbeitungseinrichtung 12 kann entweder in einigen der Kanäle oder aber auch in allen Kanälen 0 bis (M-1) eine Kaskade aus einer Transformationseinrichtung 16 zweiter Stufe, einer Filtereinrichtung 18 und einer Rücktransformationseinrichtung 20 zweiter Stufe aufweisen. In FIG 2 ist der Übersichtlichkeit halber nur für den Kanal K eine solche Kaskade dargestellt.

Die Rücktransformationseinrichtung 20 erzeugt ein Ausgangssignal S (K) erster Stufe welches zusammen mit den übrigen prozessierten oder auch nicht prozessierten Teilbandsignalen S (0) bis S (M-1) der übrigen Kanäle 0 bis (M-1) an eine Rücktransformationseinrichtung 22 erster Stufe übertragen. Die Rücktransformationseinrichtung 22 erzeugt aus ihren Eingangssignalen S (0) bis S (M-1) durch Rücktransformieren das Ausgangssignal s (t).

In FIG 2 sind nur die für die Erläuterung der Erfindung relevanten Komponenten gezeigt. Insbesondere können sich zwischen den Transformationseinrichtungen 14 und 16 bzw. zwischen den Rücktransformationseinrichtungen 20 und 22 weitere, signalverarbeitende Komponenten befinden, die etwa eine Verstärkungseinrichtung zum Anpassen des Signalpegels des Teilbandsignals Y (K) bzw. S (K) und der übrigen Teilbandsignale in Abhängigkeit von einer Hörkurve eines Benutzers der Hörvorrichtung 10 umfassen können. Genauso kann vorgesehen sein, die Teilbandsignale mittels einer Frequenzkompression spektral zu verschieben.

Bei den Transformationseinrichtungen 14 und 16 kann es sich beispielsweise um Polyphasenfilterbänke mit jeweiligen Segmentierungseinrichtungen 46 und 48 sowie einer nachgeschalteten diskreten Fourier-Transformation (DFT) 50, 52 handeln.

Im Folgenden wird die adaptive Filterung der Teilbandsignale beispielhaft anhand des Kanals K erläutert. Die eigentliche adaptive Filterung für das Teilbandsignal Y (K) des Kanals K wird durch die Filtereinrichtung 18 durchgeführt. Für die adaptive Filterung im Kanal K wird dazu aber zunächst durch die Transformationseinrichtung 16 zweiter Stufe das Teilbandsignal Y (K) in Subteilbandsignale Y (K,k) transformiert, die Signale von Subkanälen des Kanals K bilden. Durch die Transformationseinrichtung 16 kann der Kanal K beispielsweise in N = 8 oder N = 16 Subkanäle aufgeteilt werden. Entsprechend gibt es dann die Subteilbandsignale Y (K, 0) bis Y (K, N-1).

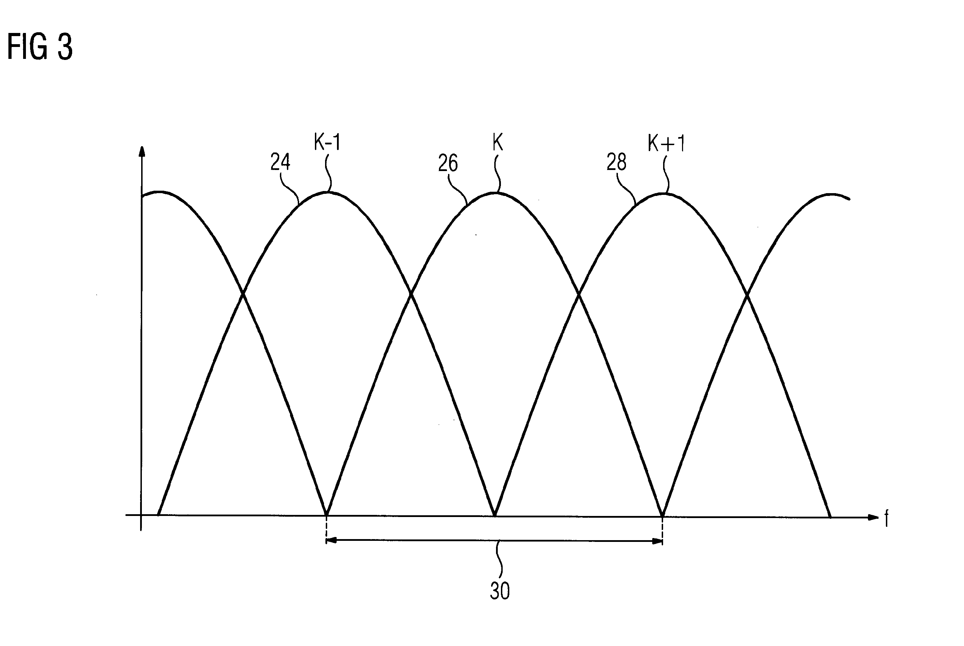

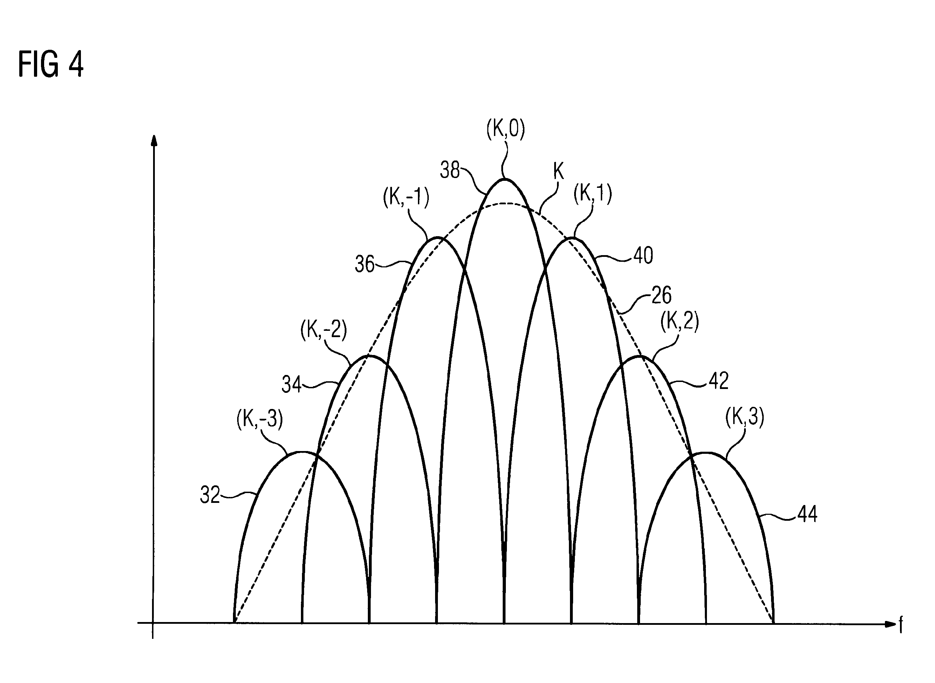

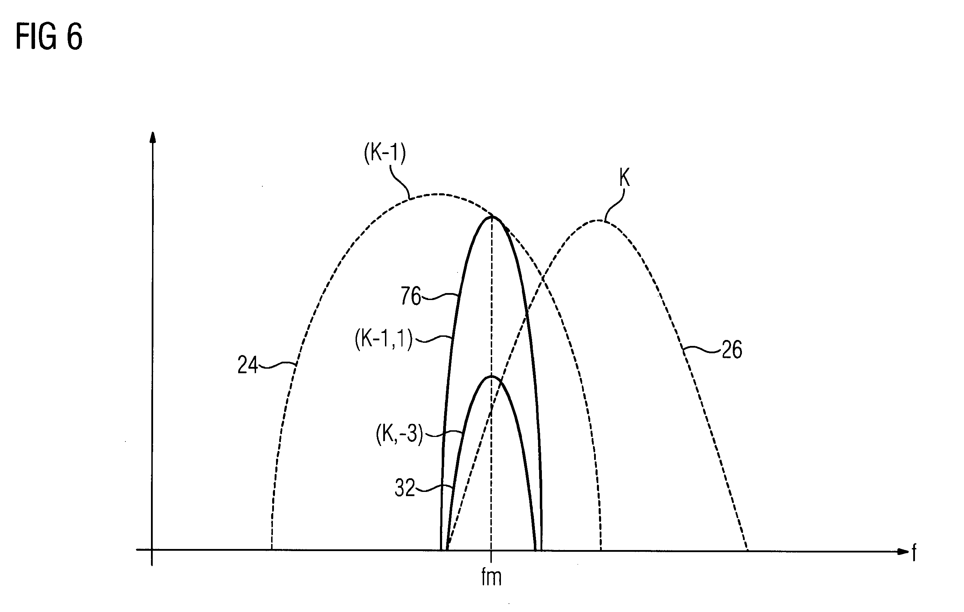

Anhand von FIG 3 und FIG 4 ist die Funktionsweise der Transformationseinrichtung 14 erster Stufe und der Transformationseinrichtung 16 der zweiten Stufe noch einmal genauer erläutert. In FIG 3 und FIG 4 (und auch in der später erläuterten FIG 6) ist als Abszisse jeweils die Dämpfung für die einzelnen Kanäle angegeben, wie sie sich in Abhängigkeit von der Frequenz f für die spektralen Anteile des Eingangssignals y (t) in den einzelnen Kanälen ergibt. Die Übertragungsfunktionen jenseits der Nulldurchgänge, welche die Durchlassbereiche begrenzen, sind dabei der Übersichtlichkeit halber nicht dargestellt.

FIG 3 zeigt schematisierte Durchlassbereiche 24, 26, 28 von Übertragungsfunktionen, wie sie sich in den Kanälen K-1, K und K+1 bezüglich des Eingangssignals y (t) ergeben. In FIG 3 sind die sogenannten Nebenmaxima der Übertragungsfunktionen nicht dargestellt. Die Durchlassbereiche 24, 26, 28 erstrecken sich jeweils zwischen zwei Nullstellen der Übertragungsfunktionen und können beispielsweise eine jeweilige Teilbandbreite 30 von 250 Hz aufweisen. Wie in FIG 3 gezeigt ist, überlappen sich die Durchlassbereiche 24, 26 der benachbarten Kanäle K-1 und K. Gleiches gilt für die benachbarten Kanäle K und K+1 (26 und 28).

In FIG 4 ist gezeigt, wie durch die Transformationseinrichtung 16 der zweiten Stufe der Kanal K in beispielsweise acht Subkanäle aufgeteilt werden kann, von denen in FIG 4 nur die Durchlassbereiche 32, 34, 36, 38, 40, 42, 44 von insgesamt 7 Subkanälen dargestellt sind. Die Indizierung der Subkanäle unterscheidet sich gegenüber der Indizierung der Kanäle (0 bis M-1) dahingegend, dass der Index 0 für den (spektral) mittigen Subkanal verwendet wird und beiderseits des mittigen Subkanals mit dem Durchlassbereich 38 zu kleinen Frequenzen hin negative Indizes und zu großen Frequenzen hin positive Indizes verwendet werden. Ein Subkanal eines bestimmten Kanals wird im Folgenden dadurch referenziert, dass zum einen der Index des Kanals und zum anderen der Index des Subkanals angegeben wird, sodass sich in FIG 4 die Subkanäle (K, -3) bis (K, 3) ergeben. Jeder dieser Subkanäle repräsentiert gemäß seinem Durchlassbereich 32 bis 44 einen Anteil des Teilbandsignals Y (K). Entsprechend werden auch die Subteilbandsignale in der oben beschriebenen Weise ebenfalls durch Angabe des Index des Kanals und des Subindex -3 bis 3 des Subkanals angegeben, also Y (K, -3) bis Y (K, 3).

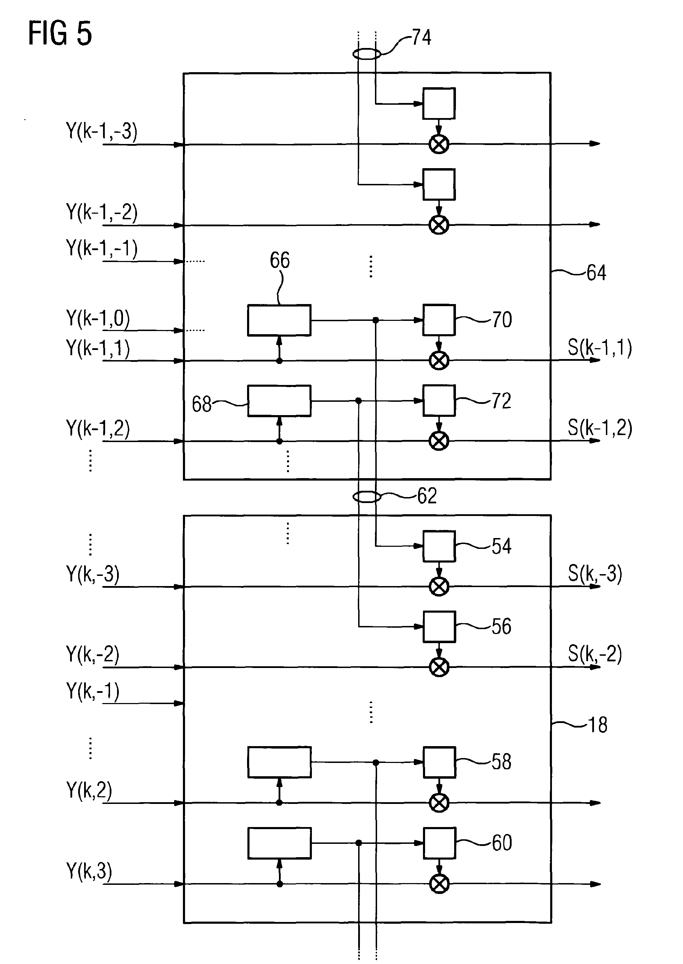

Wie in FIG 5 anhand der Subteilbandsignale Y (K, -3) und Y (K, -2) gezeigt ist, werden die Subteilbandsignale des Kanals K jeweils mit einem Gewichtungsfaktor 54, 56 multipliziert, der beispielsweise einen Wert zwischen 0 und 1 aufweisen kann. Durch einen kleinen Wert wird hierbei das jeweilige Subteilbandsignal gedämpft, während ein Wert nahe 1 dafür sorgt, dass das Ausgangssignal S (K, -2) bzw. S (K, -3) dem jeweiligen Eingangssignal Y (K, -2) bzw. Y (K, -3) entspricht. Die Gewichtungsfaktoren 54 und 56 sind dabei nicht von der Filtereinrichtung 18 selbst berechnet worden, sondern über eine Empfangseinrichtung 62 von einer Filtereinrichtung 64 des benachbarten Kanals K-1 empfangen worden. Die Filtereinrichtung 64 weist in den Subkanälen (K-1), 1) und (K-1, 2) und weiteren Subkanälen jeweils eine Schätzeinrichtung 66, 68 auf. Bei den Schätzeinrichtungen 66, 68 kann es sich beispielsweise um ein Wiener-Filter oder eine andere statistische Schätzeinrichtung handeln. Die Schätzeinrichtung 66 des Subkanals (K-1, 1) berechnet einen Gewichtungsfaktor 70 für den Subkanal (K-1, 1) in Abhängigkeit von dem Subteilbandsignal Y (K-1,1), mit dem in der beschriebenen Weise das Subteilbandsignal Y (K-1, 1) multipliziert wird, um ein gefiltertes Subteilbandsignal S (K-1, 1) zu erhalten. Zugleich wird der Gewichtungsfaktor 70 über die Empfangseinrichtung 62 der Filtereinrichtung 18 als der Gewichtungsfaktor 54 übernommen. In dem Subkanal (K-1, 2) wird durch die Schätzeinrichtung 68 ein Gewichtungsfaktor 72 in Abhängigkeit von dem Subteilbandsignal Y (K-1, 2) berechnet, der sowohl in dem Subkanal (K-1,2) selbst als auch in den Subkanal (K, -2) der Filtereinrichtung 18 als Gewichtungsfaktor 56 verwendet wird. Wie in FIG 5 ohne die in Verwendung weiterer Bezugszeichen gezeigt ist, kann auch die Filtereinrichtung 18 für andere Subkanäle, hier gezeigt für (K,2) und (K,3), selbst Schätzeinrichtungen aufweisen. Genauso kann die Filtereinrichtung 64 auch eine Empfangseinrichtung 74 aufweisen, über welche sie Gewichtungsfaktoren von einer Filtereinrichtung empfangen kann.

Im Folgenden ist anhand von FIG 6 bis FIG 10 beispielhaft erläutert, wie bei den Filtereinrichtungen 18 und 64 und den übrigen Filtereinrichtungen der Signalverarbeitungseinrichtung 12 die Aufteilung zwischen denjenigen Subkanälen, in welchen Schätzeinrichtungen wie die Schätzeinrichtung 66 und 68 vorgesehen werden, und denjenigen Subkanälen, in welchen Gewichtungsfaktoren über Empfangseinrichtungen wie die Empfangseinrichtung 62 und 74 ohne eine Berechnung ermittelt werden, zweckmäßigerweise festgelegt wird.

In FIG 6 sind dazu noch einmal die Übertragungsbereiche 24 und 26 der beiden spektral benachbarten Kanäle K-1 und K gezeigt. Durch eine (nicht dargestellte) weitere Transformationseinrichtung zweiter Stufe wird in dem Kanal K-1 das Teilbandsignal Y (K-1) in die in FIG 5 teilweise dargestellten Subteilbandsignale Y (K-1, -3) bis Y (K-1, 3) aufgeteilt. In FIG 6 ist hierzu der Durchlassbereich 76 für den Subkanal (K-1,1) dargestellt. Durch die spektrale Überlappung der beiden benachbarten Kanäle K-1 und K (siehe FIG 4) ergibt sich eine Überlappung der Durchlassbereiche 32 und 76 der Subkanäle (K-1,1) und (K,-3). Die Signalverarbeitungseinrichtung 12 ist dabei in der Weise ausgelegt, dass die Durchlassbereiche 32 und 76 eine gemeinsame Mittelfrequenz fm aufweisen, bei welchen die Übertragungsfunktionen in den beiden Durchlassbereichen 32, 76 ein Maximum aufweisen. Der Gewichtungsfaktor 70, der durch die Schätzeinrichtung 66 berechnet wird, wirkt auf das Subteilbandsignal Y (K-1, 1), das sich im Durchlassbereich 76 befindet. FIG 6 zeigt, dass der Gewichtungsfaktor 70 auch für das Subteilbandsignal Y (K,-3) im Durchlassbereich 32 verwendet werden kann. Entsprechend wird durch die Empfangseinrichtung 62 der Gewichtungsfaktor 70 in die Filtereinrichtung 18 zum Subkanal (K,-3) als Gewichtungsfaktor 54 übertragen. Entsprechendes gilt auch für den Gewichtungsfaktor 72.

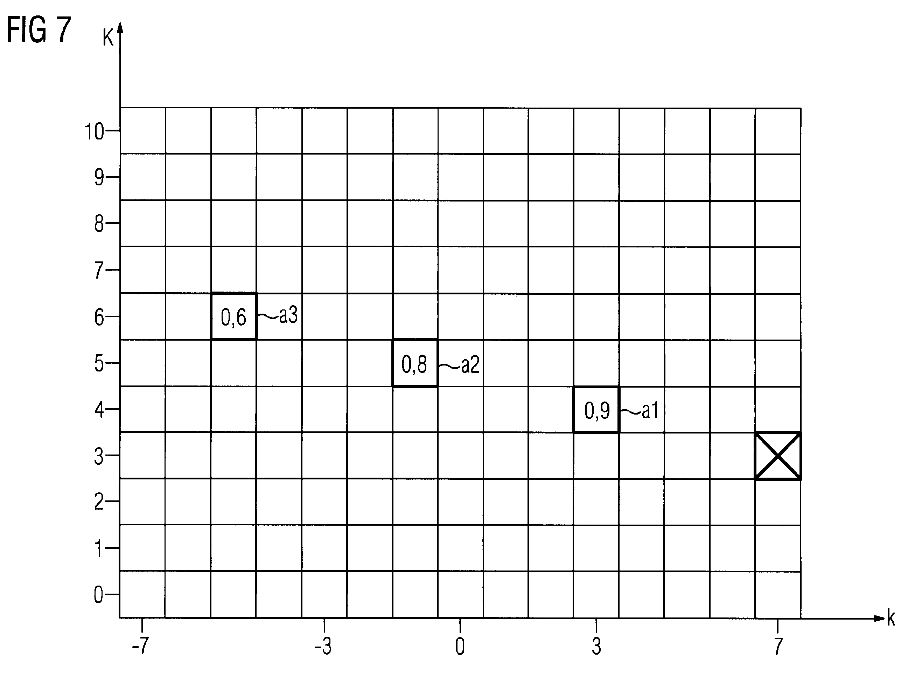

Im Folgenden ist anhand von FIG 7 bis FIG 10 für eine weitere Ausführungsform der Signalverarbeitungseinrichtung 12 erläutert, wie (aufbauend auf den obigen Erläuterungen) ein Gewichtungsfaktor nicht nur auf eine benachbarte Filtereinrichtung, sondern gleich auf mehrere, jeweils paarweise zueinander benachbarte Filtereinrichtungen übertragen werden kann. Hierzu sei auf der Grundlage von FIG 2 folgende Struktur der Signalverarbeitungseinrichtung 12 beispielhaft zugrunde gelegt.

Als Transformationseinrichtung 14 erster Stufe und Transformationseinrichtung 16 zweiter Stufe wird eine modulierte DFT Filterbank verwendet, wobei das Eingangssignal y (t) bei einer Abtastfrequenz von 16 kHz empfangen wird. Die Analysefilterbank der ersten Transformationseinrichtung 14 erzeugt mittels der Segmentierungseinrichtung 46 Segmente aus M = 64 aufeinanderfolgenden Abtastwerten bei einem Segmentvorschub von R = 16 Abtastwerten. Die einzelnen Abtastwerte der Segmente werden jeweils mit einer Hann-Fensterfunktion aus Werten $h_0$ bis $h_{M-1}$ durch Multiplizieren gewichtet. Die M = 64 Abtastwerte eines Segments werden durch die DFT 50 der Transformationseinrichtung 14 in einzelne Abtastwerte der Teilbandsignale Y(K) transformiert und mit einer reduzierten Abtastrate von 1 kHz ausgegeben. Hier steht K allgemein für den Kanalindex K = 0 bis (M-1), so dass also Y (0) bis Y (M-1) gemeint ist. Die Filterbank der Transformationseinrichtung 14 weist insgesamt eine Frequenzauflösung von 250 Hz pro Kanal auf. Durch die Transformationseinrichtung 16 des Kanals K und auch durch die übrigen Transformationseinrichtungen der anderen Kanäle wird jedes Teilbandsignal in N=16 Subteilbandsignale Y (K,k) aufgeteilt, wobei hier k im Folgenden als allgemeiner Index für das Subteilbandsignal verwendet wird, also k = -7 bis +7. Um die Subteilbandsignale zu erzeugen, wird eine Segmentiereinrichtung 48 mit einer Segmentlänge N = 16 und einem Hann-Fenster $h'_0$ bis $h'_{N-1}$ und eine DFT 52 mit der Länge N = 16 als Analysefilterbank der Transformationseinrichtung 16 der zweiten Stufe verwendet. Hieraus ergibt sich eine Frequenzauflösung von 62,5 Hz pro Subkanal. Die Frequenzauflösung hängt allgemein u.a. von der Abtastrate der Kanäle der ersten Stufe ab. Die Subteilbandsignale werden dann prozessiert, z. B. mittels einer Geräuschreduktion, wie sie durch die Filtereinrichtung 18 und die übrigen Filtereinrichtungen ermöglicht ist, indem also spektrale Gewichtungsfaktoren z.B. multiplikativ angewendet werden. Durch die Rücktransformationseinrichtung 20 ist eine Synthesefilterbank zweiter Stufe gebildet, die im Falle des Kanals K aus den gefilterten Subteilbandsignalen S (K,k) ein gefiltertes Teilbandsignal S (K) erzeugt. Die Synthesefilterbank der Rücktransformationseinrichtung 20 ist komplementär zur Synthesefilterbank der Transformationseinrichtung 16. Genauso ist durch die Rücktransformationseinrichtung 22 eine Synthesefilterbank bereitgestellt, die zur Analysefilterbank der Transformationseinrichtung 14 komplementär ist. Die Synthesefilterbanken nutzen in diesem Fall jeweils Rechteck-Fenster aus einzelnen Taps $g'_0$ bis $g'_{N-1}$ bzw. $g_0$ bis $g_{M-1}$. Es können auch andere Fensterfunktionen verwendet werden.

Die Subkanäle in der zweiten Verarbeitungsstufe mehrerer Kanäle überlappen sich spektral und es ergeben sich Mittenfrequenzen fm (K,k) für die Durchlassbereiche der einzelnen Subkanäle gemäß folgender Gleichung:

$$fm\ (K,k) = |K*\ 250\ Hz + k*\ 62,5\ Hz|.$$

Um festzulegen, welche Gewichtungsfaktoren zu berechnen sind und welche Gewichtungsfaktoren durch eine Empfangseinrichtung zu empfangen sind, wird die Kreuzkorrelation a (K,k) eines jeden Kanals (K,k) mit allen übrigen Subkanälen (K',k') mit K' = 0... M-1 und k' = -7... 7 in der folgenden Weise berechnet:

$$a(K,k) =$$
$$E\{Y(K,k)*Y^*(K',k')\} \ / \ \sqrt{[E\{|Y(K,k)|^2\}*E\{|Y^*(K',k')|^2\}]},$$

wobei E{} der Erwartungswertoperator und Y* der konjugiert komplexe Wert von Y ist. Hieraus ergibt sich ein regelmäßiges Muster, das in FIG 7 beispielhaft für die Korrelationswerte a (3, 7) des Subkanals (3, 7) gezeigt ist. Die Subbänder (K', k') = (4, 3), (5, -1) und (6, -5) sind in einem besonders hohem Maße mit den Subkanal (3, 7) korreliert. In FIG 7 sind beispielhaft mögliche Korrelationswerte a1, a2, a3 eingetragen. In den leeren Feldern sind hierbei deutlich geringere Korrelationswerte vorhanden (etwa 0,2 und weniger). Bei den mit dem Subkanal (3, 7) in hohem Maße korrelierten Subkanälen handelt es sich um solche, deren Durchlassbereich dieselbe Mittenfrequenz wie der Subkanal (3, 7) aufweist (siehe die obige Gleichung zu fm(K,k)).

Allgemeiner ergibt sich, dass bei der hier beschriebenen Filterstruktur ein Subkanal (K,k) und ein Subkanal (K+1, k-4) in einem besonders hohen Maße korreliert sind. Eine Ausnahme von diesem regelmäßigen Muster bildet nur der Subkanal für den Kanal K = 0 mit der tiefsten Mittenfrequenz. Das Signal dieses "untersten" Kanals K = 0 ist in der Regel reellwertig, woraus sich in den Subkanälen des Kanals K = 0 Signale ergeben, die zum Subkanal (0,0) spiegelsymmetrisch sind, d.h. die Subkanäle (0,-1) und (0,1) weisen Signale mit gleichem Betrag auf, genauso die Subkanäle (0,-2) und (0,2) usw.

Aufgrund der hohen Korrelationswerte von Subkanälen mit einander überlappenden Durchlassbereichen ergeben sich bei einer Berechnung von Gewichtungsfaktoren durch entsprechende Schätzeinrichtungen für all diese Subkanäle jeweils sehr ähnliche Gewichtungsfaktoren. Um den Berechnungsaufwand zu reduzieren, wird also nur ein Gewichtungsfaktor in einem dieser Subkanäle berechnet und der derart berechnete Gewichtungsfaktor in die übrigen Subkanäle kopiert. Im Extremfall muss nur ein einziger Gewichtungsfaktor pro möglicher Mittenfrequenz fm (K,k) berechnet werden

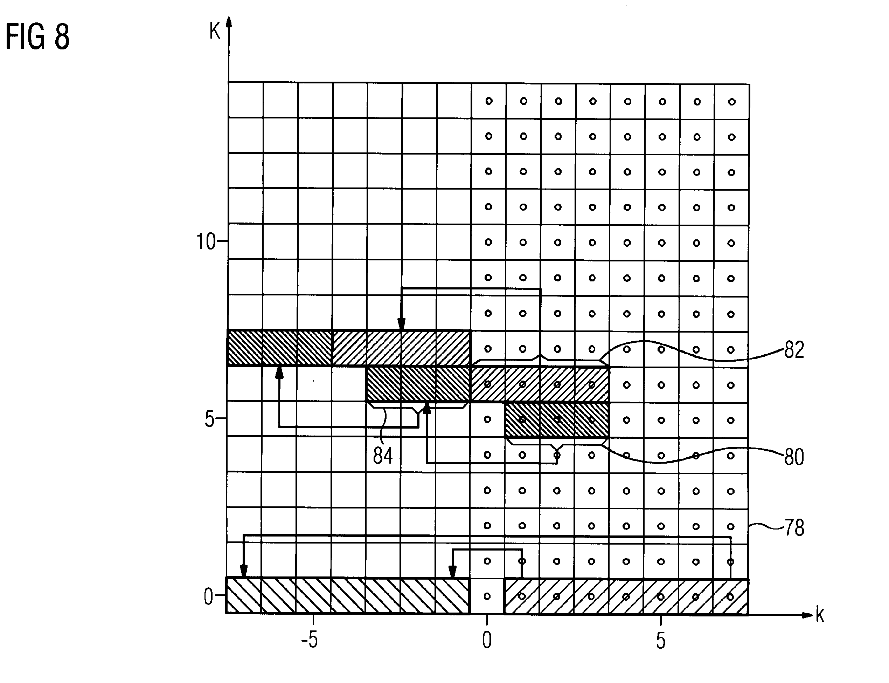

Um einen solchen effizienten Betrieb der Signalverarbeitungseinrichtung 12 zu ermöglichen, kann vorgesehen sein, sämtliche der Gewichtungsfaktoren in einem gemeinsamen Speicher 78 abzulegen, wie er beispielhaft in FIG 8, FIG 9 und FIG 10 gezeigt ist. In FIG 8 bis FIG 10 sind die einzelnen Speicherzellen gezeigt, wobei durch Indizes für die Kanäle K und deren Subkanäle k die Speicherzellen für die einzelnen Gewichtungsfaktoren kenntlich gemacht sind. Insgesamt kann jede Speicherzelle mit einem Gewichtungsfaktor gefüllt werden. Das in den FIG 8 bis FIG 10 nicht dargestellte 16-te Band wird stets zu Null gesetzt, da es einen nur unbedeutenden Anteil des Eingangssignals y(t) enthält.

Zum Übertragen von berechneten Gewichtungsfaktoren auf andere Subkanäle können nun effiziente Kopiermuster verwendet werden, welche die obige Regelmäßigkeit der Korrelation ausnutzen. Dies bedeutet, dass Gruppen 80, 82, 84 aus jeweils mehreren Gewichtungsfaktoren in einem bestimmten Kanal K stets aus Kanälen K-1, K-2 etc. mit geringerer Mittenfrequenz kopiert werden können, wenn sie dort schon einmal berechnet wurden.

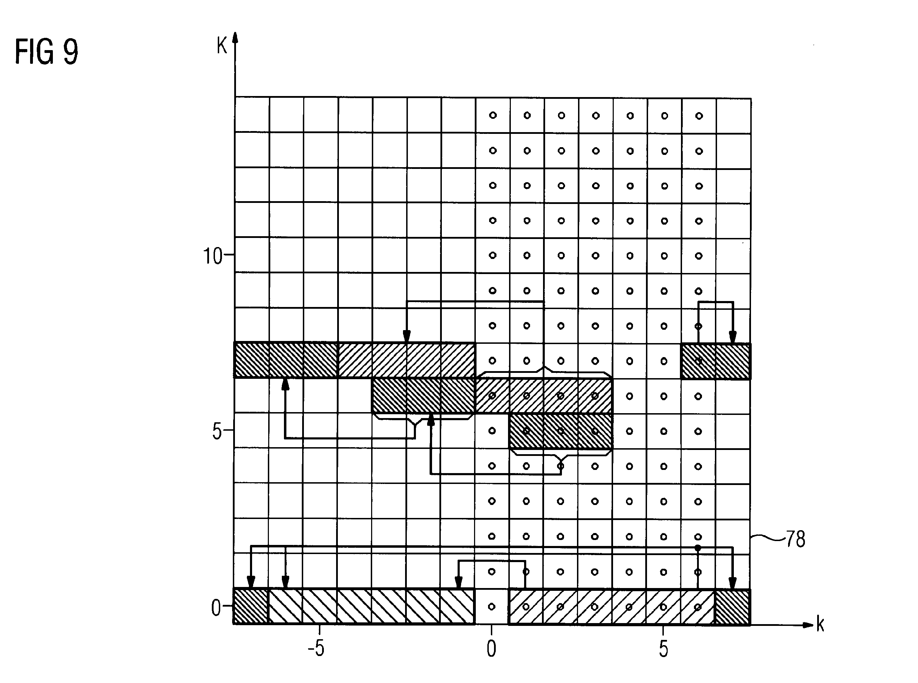

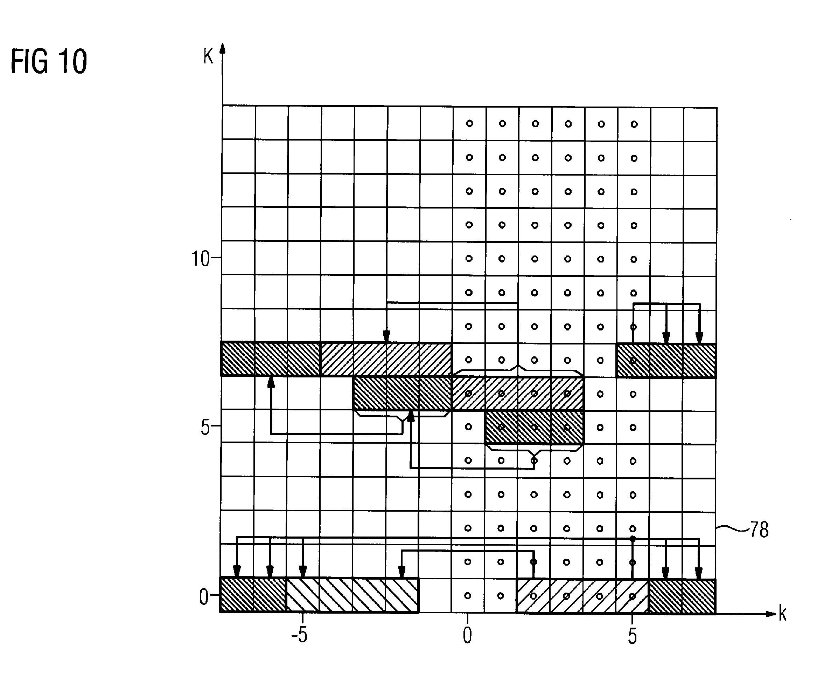

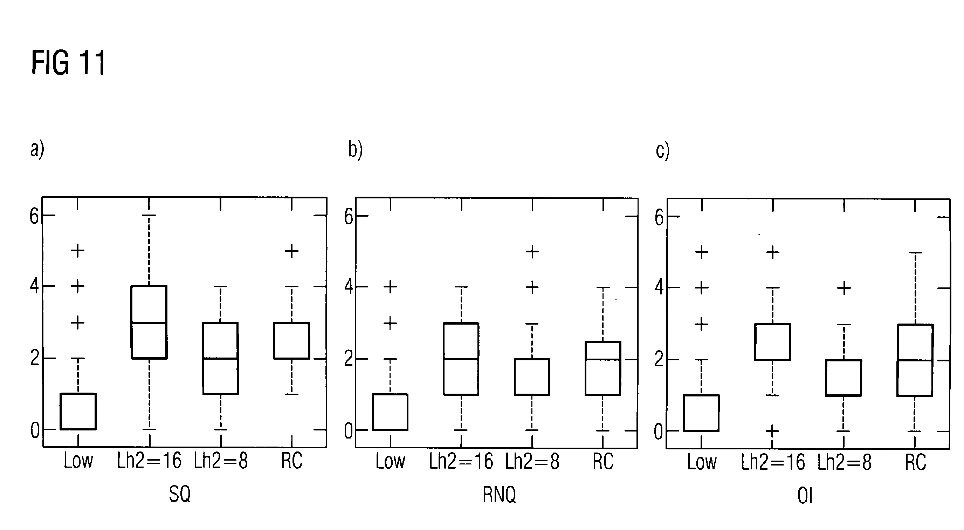

FIG 8 veranschaulicht hierzu ein mögliches Kopiermuster anhand von einzelnen Kopiervorgängen. In FIG 8 befindet sich in einigen Speicherzellen jeweils ein Punkt. In diesen Speicherzellen befinden sich Gewichtungsfaktoren, die in Abhängigkeit von den Signalen der zugehörigen Subkanäle tatsächlich von einer Schätzeinrichtung berechnet wurden (dieselbige Darstellung ist auch für FIG 9 und FIG 10 benutzt worden). Gemäß FIG 8 werden also Gewichtungsfaktoren für die Subkanäle k = 0 bis 7 stets berechnet. Die Speicherzellen, die ohne Punkt dargestellt sind, weisen zunächst keine berechneten Gewichtungsfaktoren auf. In dem Kanal K = 0 werden die Gewichtungsfaktoren spiegelsymmetrisch in die Subkanäle k = -1 bis -7 des Kanals K = 0 kopiert. Für die übrigen Kanäle K werden die fehlenden Gewichtungsfaktoren gemäß einem Kopiermuster festgelegt, das am Beispiel des Kanals K = 7 veranschaulicht ist. Die Gewichtungsfaktoren des benachbarten, tieferfrequenten Kanals K = 6 und hier der Subkanäle k = 0 bis 3 werden in den Kanal 7 in die Subkanäle k = -4 bis -1 kopiert. Die übrigen Gewichtungsfaktoren der verbleibenden Subkanäle k = -7 bis -5 werden aus dem Kanal K = 5 und hier aus dessen Subkanälen k = 1 bis 3 durch einen zweifachen Kopiervorgang wie in FIG 8 angedeutet übertragen. FIG 8 zeigt, dass also nur die Hälfte aller Gewichtungsfaktoren durch den verhältnismäßig rechenaufwendigen Schätzvorgang tatsächlich berechnet werden müssen. Zu dem Kopiermuster gemäß FIG 8 ergibt zudem ein Hörtest, dass das gefilterte Ausgangssignal s (t) durch Testhörer nicht in signifikanter Weise von einem Signal unterschieden werden kann, das mit Gewichtungsfaktoren gefiltert wurde, die für jeden Subkanal separat berechnet wurden. Ein potentiell hörbarer Unterschied ergibt sich dadurch, dass die Durchlassbereiche der einzelnen Subkanäle zwar eine gemeinsame Mittenfrequenz fm (siehe FIG 6) aufweisen können, aber die Maxima der Durchlassbereiche unterschiedlich sind. Aus diesem Grund ist es bisher auch nicht in offensichtliche Weise zu erkennen gewesen, dass die Nutzung von Gewichtungsfaktoren für mehrere Subkanäle ein derart gutes Ergebnis bei der Audioqualität ergibt. In dem Hörtest, dessen Ergebnis in FIG 11 veranschaulicht ist, sind insgesamt 20 Personen aufgefordert worden, die Qualität eines verrauschten Sprachsignals, das mit unterschiedlichen Konfigurationen gefiltert wurde, subjektiv zu beurteilen. Das Ergebnis ist aufgeteilt in a) die Sprachqualität (SQ - Speech Quality), b) die Qualität des Restrauschens (RNQ - Residual Noise Quality) und c) den Gesamteindruck (OV - Overall Impression). Die Sprachbeispiele wurden mit einer Filterbank mit geringer Frequenzauflösung (nur eine Transformationsstufe erster Stufe - LOW) einerseits und andererseits mit einer zweistufigen Filterbank einmal mit einer Transformationseinrichtung zweiter Stufe mit N = 16 (Lh2 = 16) und einmal mit einer Transformationseinrichtung zweiter Stufe mit N = 8 Subkanälen (Lh2 = 8) gefiltert. Das Ergebnis für eine zweistufige Filterbank, wie sie in FIG 2 gezeigt ist und mit N = 8 Subkanälen in der zweiten Stufe und zusätzlich der Verwendung eines Kopiermusters gemäß FIG 8 ist als RC (Reduced Complexity) gezeigt. Die Hörbeispiele umfassen dabei sowohl Sprachsignale bei einem Signal zu Rauschverhältnis von 0 dB und von -5 dB. Die Testpersonen mussten das Signal in einem Bereich von 0 (Audioqualität schlecht) bis 6 (Audioqualität gut) einstufen. Die in FIG 11 gezeigten Kästen markieren mit ihrer unteren horizontalen Kante das 25te Perzentil (P25), mit ihrer mittleren horizontalen Linie den Median (P50) und mit ihrer oberen horizontalen Kante das 75igste Perzentil (P75), sodass die Höhe der Kästen den Interquartilbereich (IQR) ergibt. Die freistehenden horizontalen Striche deuten oberhalb der jeweiligen Kästen den Wert P75 + 1,5*IQR und unterhalb der Kästen jeweils den Wert P25 - 1,5*IQR an. Die Kreuze stellen Ausreißer bei der Bewertung dar.

FIG 9 und FIG 10 veranschaulichen weitere Kopiermuster. Durch diese ist es ermöglicht, die Anzahl der benötigten Berechnungen noch weiter zu reduzieren. Hierzu wird auch innerhalb einer Filtereinrichtung der Gewichtungsfaktor des Subkanals k = 6 in den Subkanal k = 7 (FIG 9) bzw. der Gewichtungsfaktor des Subkanals k = 5 in die beiden Subkanäle k = 6 und 7 (FIG 10) kopiert.

Zusammenfassend ist festzustellen, dass durch die beschriebenen Kopiermuster der Berechnungsaufwand für die Sprachsignalverbesserung bei einer zweistufigen Filterbankanordnung um 50 Prozent und mehr verringert werden kann, ohne dass hierdurch die Sprachqualität in dem gefilterten Ausgangssignal von den Testpersonen als merklich beeinträchtigt empfunden wird. Die Kopiermuster stellen eine einfache und leicht zu implementierende Möglichkeit der Umsetzung der hier beschriebenen Erkenntnisse dar. Sie nutzen hierbei alle durch die Kreuzkorrelationen zwischen den Kanälen ermittelbaren, signifikanten Abhängigkeiten zwischen den Subkanälen. Aus dem in FIG 11 gezeigten Ergebnis des Hörtests geht klar hervor, dass sich durch die Reduzierung des Rechenaufwandes keine signifikante Einbuße bei der Audioqualität ergibt.

**Patentansprüche**

1. Verfahren zum adaptiven Filtern eines Audiosignals, indem

   - das Audiosignal durch eine erste Transformationsstufe (14) transformiert und hierdurch in mehreren Kanälen jeweils ein Teilbandsignal erzeugt wird, und
   - in zumindest einigen der Kanäle das jeweilige Teilbandsignal von einer Filtereinrichtung (18, 64) des Kanals (24, 26, 28) adaptiv gefiltert wird und hierzu in dem Kanal (24, 26, 28)
   - das Teilbandsignal von einer zweiten Transformationsstufe (16) transformiert und auf mehrere Subkanäle des Kanals (24, 26, 28) aufgeteilt wird und
   - in jedem Subkanal (32 bis 44, 76) von der Filtereinrichtung (18, 64) des Kanals (24, 26, 28) ein Gewichtungsfaktor (54 bis 60, 70, 72) für das Signal des Subkanals (32 bis 44, 76) festgelegt wird,
   **dadurch gekennzeichnet, dass**
   bei zumindest einer der Filtereinrichtungen (18, 64) der Gewichtungsfaktor (58, 60, 70, 72) zumindest eines Subkanals in Abhängigkeit von dem Signal des Subkanals (32 bis 44, 76) selbst durch Berechnen festgelegt wird und der berechnete Gewichtungsfaktor (58, 60, 70, 72) von der Filtereinrichtung (18, 64) an zumindest eine andere Filtereinrichtung (18) übertragen wird und bei der zumindest einen anderen Filtereinrichtung (18) der Gewichtungsfaktor (54, 56) zumindest eines Subkanals (32 bis 44, 76) anhand des empfangenen, berechneten Gewichtungsfaktors (58, 60, 70, 72, 80 bis 84) festgelegt wird.

2. Verfahren nach Anspruch 1, wobei der berechnete Gewichtungsfaktor eines ersten Subkanals (76) zu einen Subkanal (32) hin übertragen wird, der sich mit dem ersten Subkanal (76) spektral überschneidet und der insbesondere dieselbe Mittenfrequenz (fm) wie der erste Subkanal (76) aufweist.

3. Verfahren nach Anspruch 1 oder 2, wobei der berechnete Gewichtungsfaktor (58, 60, 70, 72) eines ersten Subkanals (76) zu einen Subkanal (32) hin übertragen wird, bei welchem ein Wert (a1, a2, a3) für die Kreuzkorrelation zwischen seinem eigenen Signal und dem Signal des ersten Subkanals (76) größer als ein vorbestimmter Schwellenwert ist.

4. Verfahren nach einem der vorhergehenden Ansprüche, wobei zumindest ein Gewichtungsfaktor (54, 56) auf denselben Wert festgelegt wird wie ihn der empfangene, berechnete Gewichtungsfaktor (70, 72) aufweist.

5. Verfahren nach einem der vorhergehenden Ansprüche, wobei mehrere berechnete Gewichtungsfaktoren (80, 82, 84) benachbarter Subkanäle eines ersten Kanals gemäß einem vorbestimmten Kopiermuster in einen Speicher (78) einer Filtereinrichtung (18, 64) eines zweiten Kanals übertragen werden, wo sie die Gewichtungsfaktoren benachbarter Subkanäle des zweiten Kanals bilden.

6. Verfahren nach einem der vorhergehenden Ansprüche, wobei zumindest ein Gewichtungsfaktor (80) einer ersten Filtereinrichtung (18, 64) insgesamt an zumindest zwei weitere Filtereinrichtungen (18, 64) übertragen wird.

7. Verfahren nach einem der vorhergehenden Ansprüche, wobei auch innerhalb zumindest einer der Filtereinrichtungen (18, 64) ein Gewichtungsfaktor zu einem anderen Subkanal derselben Filtereinrichtung übertragen wird.

8. Verfahren nach einem der vorhergehenden Ansprüche, wobei die Filtereinrichtungen (18, 64) zu benachbarten Kanälen (24 bis 28) gehören und alle zu übertragenden Gewichtungsfaktoren (58, 60, 70, 72, 80 bis 84) nur frequenzaufwärts zu einer Filtereinrichtung eines Kanals mit einer höheren Mittenfrequenz oder nur frequenzabwärts zu einer Filtereinrichtung eines Kanals mit niedrigerer Mittenfrequenz übertragen werden.

9. Verfahren nach einem der vorhergehenden Ansprüche, wobei mehrere benachbarte Kanäle (24 bis 28) jeweils eine Filtereinrichtung (18, 64) aufweisen und bei jeder der Filtereinrichtungen (18, 64)

   a) die Gewichtungsfaktoren (58, 60, 70, 72, 80 bis 84) in einigen der Subkanäle (38 bis 44, 76) durch Berechnung oder durch Vorgeben eines vorbestimmten Werts festgelegt werden und
   b) die Gewichtungsfaktoren (54, 56) anderer Subkanäle (32 bis 36) von wenigstens einer anderen Filtereinrichtung (18, 64) empfangen werden.

10. Verfahren nach einem der vorhergehenden Ansprüche, wobei von der Filtereinrichtung (18, 64) zumindest eines Kanals (24 bis 28) zum adaptiven Filtern des Teilbandsignals

    a) das Signal jedes Subkanals (32 bis 44, 76) gemäß dem festgelegten Gewichtungsfaktor (58, 60, 70, 72, 80 bis 84) gewichtet wird und
    b) die gewichteten Signale aller Subkanäle (32 bis 44, 76) des Kanals (24 bis 28) zusammen durch eine Rücktransformationsstufe (20) zurück transformiert und zu einem gefilterten Teilbandsignal kombiniert werden.

11. Verfahren nach einem der vorhergehenden Ansprüche, wobei von der Filtereinrichtung zumindest eines Kanals zum adaptiven Filtern des Teilbandsignals

    a) die Gewichtungsfaktoren aller Subkanäle durch eine Rücktransformationsstufe gemeinsam zurück transformiert und zu einer Filterfunktion kombiniert werden und
    b) ein gefiltertes Teilbandsignal durch Filtern des Teilbandsignals mit der Filterfunktion erzeugt wird.

12. Hörvorrichtung (10) mit

    - einer Transformationseinrichtung (14) erster Stufe, wobei die Transformationseinrichtung (14) erster Stufe dazu ausgelegt ist, ein Signal durch Transformieren auf mehrere Kanäle (24 bis 28) aufzuteilen,
    - zumindest zwei Transformationseinrichtungen (16) zweiter Stufe, wobei jede Transformationseinrichtung (16) zweiter Stufe dazu ausgelegt ist, das Signal eines der Kanäle (24 bis 28) durch Transformieren auf Subkanäle (32 bis 44) des Kanals (24 bis 26) aufzuteilen,
    - einer Filtereinrichtung (18, 64) in jedem Kanal (24 bis 28), der eine Transformationseinrichtung (16) zweiter Stufe aufweist, wobei jede der Filtereinrichtungen (18, 64) dazu ausgelegt ist, das Signal des Kanals (24 bis 28) in Abhängigkeit von zu den Subkanälen (32 bis 44) ermittelten Gewichtungsfaktoren (54 bis 60, 70, 72) zu filtern, und wobei die Filtereinrichtung (18, 64) in einigen Subkanälen (32 bis 44) jeweils eine Schätzeinrichtung (66, 68) aufweist, die dazu ausgelegt ist, den Gewichtungsfaktor (70, 72) des Subkanals (32 bis 44) in Abhängigkeit von dem Signal des Subkanals (32 bis 44) zu berechnen, und in einigen anderen Subkanälen (32 bis 44) jeweils eine Empfangseinrichtung (62, 74) aufweist, die dazu ausgelegt ist, einen berechneten Gewichtungsfaktor (58, 60, 70, 72) von einer anderen Filtereinrichtung (18, 64) zu empfangen und als den Gewichtungsfaktor (54, 56) des Subkanals (32 bis 44) festzulegen.

13. Hörvorrichtung nach Anspruch 12, wobei sich benachbarte Kanäle (24 bis 26) spektral überlappen und hierbei insbesondere ein Subkanal (76) eines ersten Kanals (24) und ein Subkanal (32) eines zweiten Kanals (26) dieselbe Mittenfrequenz (fm) aufweisen.

14. Hörvorrichtung nach Anspruch 12 oder 13, wobei die Schätzeinrichtungen (66, 68) jeweils einen statistischen Schätzer für einen Nutzsignalanteil des Signals des jeweiligen Subkanals (32 bis 44, 76), insbesondere einen Wiener-Filter, umfassen und die Gewichtungsfaktoren (54 bis 60, 70, 72) jeweils einen Filtergain darstellen.

15. Hörvorrichtungen nach einem der Ansprüche 12 bis 14, wobei zumindest eine der Transformationseinrichtungen (14, 16) eine spektrale Transformation (50, 52), insbesondere eine diskrete Fourier-Transformation (50, 52), und/oder eine Filterbank (46, 50; 48, 52), insbesondere eine Polyphasenfilterbank (46, 50; 48, 52), umfasst.

16. Hörvorrichtung nach einem der Ansprüche 12 bis 15, wobei eine Rücktransformationseinrichtung (20, 22) bereitgestellt ist, die dazu ausgelegt ist, Ausgangssignale der Filtereinrichtungen (18, 64) zurück zu transformieren und hierdurch ein gefiltertes Audiosignal zu erzeugen.

## Claims

1. Method for adaptive filtering of an audio signal, in that

   - the audio signal is transformed by a first transformation stage (14) and this produces a respective sub-band signal in a plurality of channels, and
   - in at least some of the channels the respective sub-band signal is adaptively filtered by a filter device (18, 64) of the channel (24, 26, 28), and to this end, in the channel (24, 26, 28),
   - the sub-band signal is transformed by a second transformation stage (16) and split over a plurality of sub-channels of the channel (24, 26, 28), and
   - in each sub-channel (32 to 44, 76) the filter device (18, 64) of the channel (24, 26, 28) stipulates a weighting factor (54 to 60, 70, 72) for the signal of the sub-channel (32 to 44, 76),
   **characterized in that**
   in the case of at least one of the filter devices (18, 64) the weighting factor (58, 60, 70, 72) of at least one sub-channel is stipulated by computation on the basis of the signal of the sub-channel (32 to 44, 76) itself, and the computed weighting factor (58, 60, 70, 72) is transmitted from the filter device (18, 64) to at least one other filter device (18), and in the case of the at least one other filter device (18) the weighting factor (54, 56) of at least one sub-channel (32 to 44, 76) is stipulated on the basis of the received, computed weighting factor (58, 60, 70, 72, 80 to 84).

2. Method according to Claim 1, wherein the computed weighting factor of a first sub-channel (76) is transmitted to a sub-channel (32) that overlaps the first sub-channel (76) in terms of spectrum and that has particularly the same centre frequency (fm) as the first sub-channel (76).

3. Method according to Claim 1 or 2, wherein the computed weighting factor (58, 60, 70, 72) of a first sub-channel (76) is transmitted to a sub-channel (32) for which a value (a1, a2, a3) for the cross-correlation between its own signal and the signal of the first sub-channel (76) is greater than a predetermined threshold value.

4. Method according to one of the preceding claims, wherein at least one weighting factor (54, 56) is stipulated to be the same value as that which the received, computed weighting factor (70, 72) has.

5. Method according to one of the preceding claims, wherein a plurality of computed weighting factors (80, 82, 84) of adjacent sub-channels of a first channel are transmitted in accordance with a predetermined copy pattern to a memory (78) of a filter device (18, 64) of a second channel, where they form the weighting factors of adjacent sub-channels of the second channel.

6. Method according to one of the preceding claims, wherein at least one weighting factor (80) of a first filter device (18, 64) is transmitted to at least two further filter devices (18, 64) in total.

7. Method according to one of the preceding claims, wherein within at least one of the filter devices (18, 64) a weighting factor is also transmitted to another sub-channel of the same filter device.

8. Method according to one of the preceding claims, wherein the filter devices (18, 64) belong to adjacent channels (24 to 28) and all the weighting factors (58, 60, 70, 72, 80 to 84) to be transmitted are transmitted only upwards in terms of frequency to a filter device of a channel having a higher centre frequency or only downwards in terms of frequency to a filter device of a channel having a lower centre frequency.

9. Method according to one of the preceding claims, wherein a plurality of adjacent channels (24 to 28) have a respective filter device (18, 64) and, in the case of each of the filter devices (18, 64),

   a) the weighting factors (58, 60, 70, 72, 80 to 84) in some of the sub-channels (38 to 44, 76) are stipulated by computing or by prescribing a predetermined value and
   b) the weighting factors (54, 56) of other sub-channels (32 to 36) are received from at least one other filter device (18, 64).

10. Method according to one of the preceding claims, wherein the filter device (18, 64) of at least one channel (24 to 28) for adaptive filtering of the sub-band signal

    a) weights the signal of each sub-channel (32 to 44, 76) in accordance with the stipulated weighting factor (58, 60, 70, 72, 80 to 84) and
    b) transforms back the weighted signals of all the sub-channels (32 to 44, 76) of the channel (24 to 28) together using a back-transformation stage (20) and combines them to form a filtered sub-band signal.

11. Method according to one of the preceding claims, wherein the filter device of at least one channel for adaptive filtering of the sub-band signal

    a) transforms back the weighting factors of all the sub-channels jointly using a back-transformation stage and combines them to form a filter function and
    b) produces a filtered sub-band signal by filtering the sub-band signal using the filter function.

12. Hearing apparatus (10) having

    - a first-level transformation device (14), wherein the first-level transformation device (14) is designed to split a signal over a plurality of channels (24 to 28) by means of transformation,
    - at least two second-level transformation devices (16), wherein each second-level transformation device (16) is designed to split the signal of one of the channels (24 to 28) over sub-channels (32 to 44) of the channel (24 to 26) by means of transformation,
    - a filter device (18, 64) in each channel (24 to 28) that has a second-level transformation device (16), wherein each of the filter devices (18, 64) is designed to filter the signal of the channel (24 to 28) on the basis of weighting factors (54 to 60, 70, 72) ascertained for the sub-channels (32 to 44), and wherein the filter device (18, 64) has a respective estimation device (66, 68) in some sub-channels (32 to 44), said estimation device being designed to compute the weighting factor (70, 72) of the sub-channel (32 to 44) on the basis of the signal of the sub-channel (32 to 44), and has a respective reception device (62, 74) in some other sub-channels (32 to 44), said reception device being designed to receive a computed weighting factor (58, 60, 70, 72) from another filter device (18, 64) and to stipulate it as the weighting factor (54, 56) of the sub-channel (32 to 44).

13. Hearing apparatus according to Claim 12, wherein adjacent channels (24 to 26) overlap in terms of spectrum, and in this case particularly a sub-channel (76) of a first channel (24) and a sub-channel (32) of a second channel (26) have the same centre frequency (fm) .

14. Hearing apparatus according to Claim 12 or 13, wherein the estimation devices (66, 68) comprise a respective statistical estimator for a useful signal component of the signal of the respective sub-channel (32 to 44, 76), particularly a Wiener filter, and the weighting factors (54 to 60, 70, 72) each represent a filter gain.

15. Hearing apparatus according to one of Claims 12 to 14, wherein at least one of the transformation devices (14, 16) comprises a spectral transformation (50, 52), particularly a discrete Fourier transformation (50, 52), and/or a filter bank (46, 50; 48, 52), particularly a polyphase filter bank (46, 50; 48, 52).

16. Hearing apparatus according to one of Claims 12 to 15, wherein a back-transformation device (20, 22) is provided that is designed to transform back output signals from the filter devices (18, 64) and thereby to produce a filtered audio signal.

**Revendications**

1.  Procédé de filtrage adaptatif d'un signal audio, dans lequel
    le signal audio est transformé par un premier étage de transformation (14) pour ainsi former des signaux en bande partielle dans plusieurs canaux,
    dans au moins certain des canaux, le signal en bande partielle est filtré de manière adaptative par un dispositif de filtrage (18, 64) du canal (24, 26, 28) et dans ce but,
    le signal en bande partielle est transformé dans le canal (24, 26, 28) par un deuxième étage de transformation (16) et est divisé en plusieurs sous-canaux du canal (24, 26, 28),
    un facteur de pondération (54 à 60, 70, 72) du signal du sous-canal (32 à 44, 76) est défini dans chaque sous-canal (32 à 44, 76) par le dispositif de filtrage (18, 64) du canal (24, 26, 28),
    **caractérisé en ce que**
    le facteur de pondération (58, 60, 70, 72) d'au moins un sous-canal est défini par calcul dans au moins l'un des dispositifs de filtrage (18, 64) en fonction du signal du sous-canal (32 à 44, 76) proprement dit,
    **en ce que** le facteur de pondération (58, 60, 70, 72) calculé par le dispositif de filtrage (18, 64) est transmis à au moins un autre dispositif de filtrage (18) et
    **en ce que** le facteur de pondération (54, 56) d'au moins un sous-canal (32 à 44, 76) est défini dans le ou les autres dispositifs de filtrage (18) à l'aide du facteur de pondération (58, 60, 70, 72, 80 à 84) calculé ainsi reçu.

2.  Procédé selon la revendication 1, dans lequel le facteur de pondération calculé d'un premier sous-canal (76) est transmis à un sous-canal (32) qui recoupe spectralement le premier sous-canal (76) et qui présente en particulier la même fréquence centrale (fm) que le premier sous-canal (76).

3.  Procédé selon les revendications 1 ou 2, dans lequel le facteur de pondération (58, 60, 70, 72) calculé pour un premier sous-canal (76) est transmis à un sous-canal (32) pour lequel une valeur (a1, a2, a3) de la corrélation croisée entre son signal propre et le signal du premier sous-canal (76) est supérieur à une valeur de seuil prédéterminée.

4.  Procédé selon l'une des revendications précédentes, dans lequel au moins un facteur de pondération (54, 56) est défini à la même valeur que celle que présente le facteur de pondération (70, 72) calculé qui a été reçu.

5.  Procédé selon l'une des revendications précédentes, dans lequel plusieurs facteurs de pondération (80, 82, 84) calculés sur des sous-canaux voisins d'un premier canal sont transmis selon un motif de copie prédéterminé dans une mémoire (78) d'un dispositif de filtrage (18, 64) d'un deuxième canal dans lequel il forme les facteurs de pondération de sous-canaux voisins du deuxième canal.

6.  Procédé selon l'une des revendications précédentes, dans lequel au moins un facteur de pondération (80) d'un premier dispositif de filtrage (18, 64) est transmis globalement à au moins deux autres dispositifs de filtrage (18, 64).

7.  Procédé selon l'une des revendications précédentes, dans lequel à l'intérieur d'au moins l'un des dispositifs de filtrage (18, 64), un facteur de pondération est également transmis à un autre sous-canal du même dispositif de filtrage.

8.  Procédé selon l'une des revendications précédentes, dans lequel les dispositifs de filtrage (18, 64) font partie des canaux voisins (24 à 28) et tous les facteurs de pondération (58, 60, 70, 72, 80 à 84) à transmettre ne sont transmis uniquement en fréquence montante vers un dispositif de filtrage d'un canal présentant une fréquence centrale plus élevée ou uniquement en fréquence descendante vers un dispositif de filtrage d'un canal dont la fréquence centrale est plus basse.

9.  Procédé selon l'une des revendications précédentes, dans lequel plusieurs canaux (24 à 28) voisins présentent chacun un dispositif de filtrage (18, 64) et pour chacun des dispositifs de filtrage (18, 64), a) les facteurs de pondération (58, 60, 70, 72, 80 à 84) dans l'un des sous-canaux (38 à 44, 76) sont définis par calcul ou par imposition d'une valeur prédéterminée et b) les facteurs de pondération (54, 56) d'autres sous-canaux (32 à 36) sont reçus par au moins un autre dispositif de filtrage (18, 64).

10. Procédé selon l'une des revendications précédentes, dans lequel, pour le filtrage adaptatif du signal en bande partielle, le dispositif de filtrage (18, 64) d'au moins un canal (24 à 28)

a) pondère le signal de chaque sous-canal (32 à 44, 76) selon le facteur de pondération (58, 60, 70, 72, 80 à 84) défini et

b) retransforme conjointement par un étage de rétro-transformation (20) les signaux pondérés de tous les sous-canaux (32 à 44, 76) du canal (24 à 28) et les combine pour former un signal en mode partiel filtré.

**11.** Procédé selon l'une des revendications précédentes, dans lequel, pour le filtrage adaptatif du signal en bande partielle, le dispositif de filtrage d'au moins un canal

a) retransforme conjointement les facteurs de pondération de tous les sous-canaux par un étage de rétro-transformation et les combine en une fonction de filtrage et

b) forme un signal en bande partielle filtré par filtrage du signal en bande partielle par la fonction de filtrage.

**12.** Ensemble d'audition (10) présentant

un dispositif de transformation (14) de premier étage, le dispositif de transformation (14) du premier étage étant conçu pour diviser un signal en plusieurs canaux (24 à 28) par transformation,

au moins deux dispositifs de transformation (16) de deuxième étage, chaque dispositif de transformation (16) de deuxième étage étant conçu pour diviser le signal d'un des canaux (24 à 28) sur des sous-canaux (32 à 44) du canal (24 à 26) par transformation,

un dispositif de filtrage (18, 64) prévu dans chaque canal (24 à 28) et présentant un dispositif de transformation (16) de deuxième étage, chacun des dispositifs de filtrage (18, 64) étant conçu pour filtrer le signal du canal (24 à 28) en fonction de facteurs de pondération (54 à 60, 70, 72) déterminés pour les sous-canaux (32 à 44), le dispositif de filtrage (18, 64) présentant un dispositif d'estimation (66, 68) dans certains des sous-canaux (32 à 44) conçu pour calculer le facteur de pondération (70, 72) du sous-canal (32 à 44) en fonction du signal du sous-canal (32 à 44) et présentant dans certains autres sous-canaux (32 à 44) un dispositif de réception (62, 74) conçu pour recevoir un facteur de pondération (58, 60, 70, 72) calculé d'un autre dispositif de filtrage (18, 64) et de le définir comme facteur de pondération (54, 56) du sous-canal (32 à 44).

**13.** Ensemble d'audition selon la revendication 12, dans lequel des canaux voisins (24 à 26) se superposent spectralement et un sous-canal (76) d'un premier canal (24) ainsi qu'un sous-canal (32) d'un deuxième canal (26) présentent la même fréquence centrale (fm).

**14.** Ensemble d'audition selon les revendications 12 ou 13, dans lequel les dispositifs d'estimation (66, 68) comprennent chacun un estimateur statistique d'une partie utile du signal de chaque sous-canal (32 à 44, 76), en particulier un filtre de Wiener, et les facteurs de pondération (54 à 60, 70, 72) représentent chacun un gain de filtrage.

**15.** Dispositifs d'audition selon l'une des revendications 12 à 14, dans lequel au moins l'un des dispositifs de transformation (14, 16) comporte une transformation spectrale (50, 52), notamment une transformation discrète de Fourier (50, 52) et/ou une banque de filtres (46, 50; 48, 52), en particulier une banque de filtres polyphasés (46, 50; 48, 52).

**16.** Ensemble d'audition selon l'une des revendications 12 à 15, dans lequel un dispositif (20, 22) de rétro-transformation est prévu et conçu pour retransformer les signaux de sortie des dispositifs de filtrage (18, 64) et former ainsi un signal audio filtré.

# FIG 1
(Stand der Technik)

# FIG 2

EP 2 629 550 B1

FIG 3

FIG 4

## FIG 5

FIG 6

EP 2 629 550 B1

FIG 7

FIG 8

FIG 9

EP 2 629 550 B1

FIG 10

EP 2 629 550 B1

FIG 11

a) SQ

b) RNQ

c) OI

## IN DER BESCHREIBUNG AUFGEFÜHRTE DOKUMENTE

**In der Beschreibung aufgeführte Patentdokumente**

- DE 102010026884

**In der Beschreibung aufgeführte Nicht-Patentliteratur**

- Low delay filter-banks für speech und audio processing. **H. W. LÖLLMANN ; P. VARY ; EBERHARD HÄNSLER ; GERHARD SCHMIDT.** Speech and Audio Processing in Adverse Environments. Springer, 2008